# EUROPÄISCHE PATENTSCHRIFT

(11) **EP 1 239 295 B1**
(45) Veröffentlichungstag und Bekanntmachung des Hinweises auf die Patenterteilung: **20.01.2010**
(21) Anmeldenummer: 02004159.6
(22) Anmeldetag: 26.02.2002
(51) Int. Cl.: G01R 33/30

(54) **Vorrichtung zum Transport sowie zur exakten Positionierung eines Probengläschens in einem hochauflösenden NMR-Spektrometer**
Device for transport and exact positioning of a sample tube in a high resolution NMR spectrometer
Agencement pour le transport et le positionnement exact d'une éprouvette dans un spectromètre RMN à haute résolution

(30) Priorität: 09.03.2001 DE 10111674
(43) Veröffentlichungstag der Anmeldung: 11.09.2002
(73) Patentinhaber: Bruker BioSpin AG, 8117 Fällanden (CH)
(72) Erfinder: Tschirky, Hansjörg, 4107 Ettingen (CH); Warden, Michael, 8118 Pfaffhausen (CH); Seydoux, Roberto, 8604 Volketswil (CH); Marek, Daniel, 5103 Möriken (CH)
(74) Vertreter: Kohler Schmid Möbus

(56) Entgegenhaltungen:
- DE-A- 19 509 062

## Beschreibung

Die Erfindung betrifft eine Vorrichtung zum Transport eines mit einer Messsubstanz gefüllten länglichen Probenröhrchens in den Messraum eines Kemspinresonanz (=NMR)-Magnetsystems sowie zur Positionierung des Probenröhrchens relativ zur Vertikalachse eines NMR-Empfangspulensystems mit einem Spinner; der Teil einer Luftturbine ist und eine axiale Durchgangsbohrung aufweist, durch welche das Probenröhrchen gesteckt, zusammen mit dem Spinner auf einem Luftkissen in den Messraum befördert und dort relativ zur Vertikalachse des NMR-Empfangspulensystems positioniert werden kann, wobei eine manschettenartig und verrutschsicher radial um das Probenröhrchen herum angebrachte Befestigungshülse vorgesehen ist, und wobei die Bohrung in einer ersten Stufe im oberen Bereich des Spinners einen Innendurchmesser aufweist, der größer ist als der Außendurchmesser der Befestigungshülse, und in einer zweiten Stufe im Bodenbereich des Spinners einen Innendurchmesser aufweist, der kleiner ist als der Außendurchmesser der Befestigungshülse , aber größer als der Außendurchmesser des Probenröhrchens.

Eine solche Vorrichtung ist beispielsweise bekannt aus DE 195 09 062 A1.

NMR-Spektrometer arbeiten heute fast ausschließlich mit supraleitenden Magnetsystemen, bei denen sich der Messraum tief unten im Raumtemperatur-Rohr (= RT-Rohr) des Magnet-Kryostaten befindet. Der Zugang zu diesem Messraum ist deshalb nur mit Hilfsvonichtungen möglich, die vorzugsweise pneumatisch, d.h. mit Druckluft, arbeiten. Die Verwendung von Druckluft ist naheliegend, weil diese auch für die Luftturbine, mit der die Rotation des NMR-Probenröhrchens erzeugt wird, benötigt wird.

Im Innern des RT-Rohrs befindet sich normalerweise eine Trägervorrichtung, an die der NMR-Probenkopf angeschraubt werden kann. Diese Trägervorrichtung besitzt im oberen Teil ein Führungsrohr, das den Zugang zum Messraum und dem knapp darüber liegenden Stator der Luftturbine gewährleistet. Der Rotor (= Spinner) der Luftturbine, in der die Messprobe steckt, ist so bemessen, dass er mit wenig Spielraum in das Führungsrohr passt. Er hat zwei Funktionen zu erfüllen: Erstens Beförderung der Messprobe in den Messraum, und zweitens Erzeugung einer Rotation der Messprobe.

Um den Spinner samt Probenröhrchen in den Messraum zu befördern, wird vom Messraum her Pressluft eingeblasen, die nach oben fließt und durch die obere Öffnung des Führungsrohrs nach außen entweicht. Anschließend wird der Spinner samt Pobengläschen auf die obere Öffnung des Führungsrohrs gesetzt, und da der Spinner diese Öffnung fast vollständig abdeckt, entsteht ein Überdruck im Innern des Führungsrohrs, so dass der Spinner auf einem Luftpolster zu liegen kommt. Wird nun die Pressluftmenge reduziert, so erreicht man nach einer gewissen Zeit den Zustand, wo die von der Pressluft erzeugten Kraft, die den Spinner oben hält, kleiner als das Gewicht des Spinners samt Messprobe wird, und der Spinner auf dem Luftpolster langsam nach unten zu gleiten beginnt. Wie schnell dieser Spinner nach unten gleitet ist natürlich vom eingestellten Druck der Pressluft abhängig, und so kann es vorkommen, dass der Spinner mit seinem Probenröhrchen relativ hart auf diverse Konstruktionsteile im Bereich des Messraums auftreffen kann.

Solange Probenröhrchen mit Durchmessern von 5mm, und darüber verwendet wurden, führte das oben geschilderte Transportverfahren zu keinen ernsthaften Problemen. Kritisch wurde es jedoch bei kleineren Durchmessern, d.h. bei Messkapillaren mit einem Durchmesser von z.B. 2mm, weil diese sehr zerbrechlich sind und kleinste Schläge zu einem Glasbruch führen können. Für Messkapillaren mit einem Durchmesser von 1 mm ist die Gefahr eines Glasbruchs sogar derart gross, dass deren Verwendung kaum noch zu vertreten ist.

Trotzdem besteht in der NMR eine starke Nachfrage nach solchen kleinsten Messkapillaren, da oft nur sehr geringe Mengen an Messsubstanz zur Verfügung stehen. Die Entwicklung von neuen und besseren Transportverfahren für Messkapillaren ist deshalb für die NMR-Spektroskopie von großer Bedeutung.

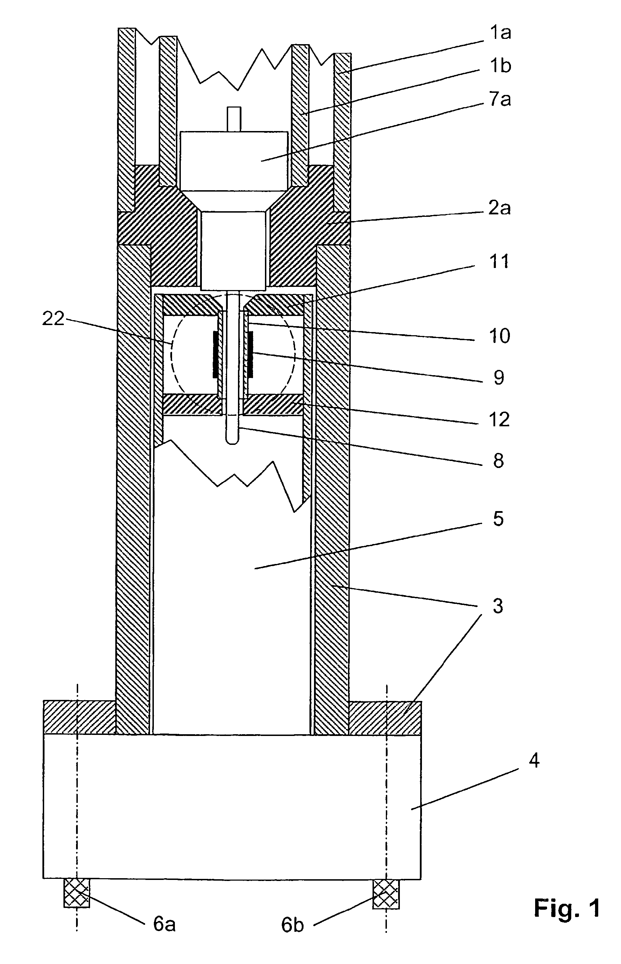

Die Bereitstellung von NMR-Messproben für Messungen in einem NMR-Spektrometer erfolgt normalerweise in zwei Schritten. Im ersten Schritt (= Vorbereitungsphase) wird die Messsubstanz in eine Messkapillare 8 aus Glas abgefüllt (= Sample), und die Messkapillare anschließend zugeschweißt oder mit einer Kappe abgedeckt. Im zweiten Schritt (= Transportphase) wird der Spinner samt Messkapillare mit Hilfe einer pneumatischen Vorrichtung durch ein Führungsrohr 1b vom oberen Teil des NMR-Magnetsystems bis hinunter zum Stator 2a der Luftturbine befördert, wobei der Spinner diesen Weg auf einem Luftpolster liegend hinter sich bringt. Der Spinner liegt am Ende dieses Vorgangs auf der konischen Fläche des Stators und wird dort sowohl in der Höhe (= axial) wie auch seitlich (= radial) zentriert (siehe Fig. 1). Dank dieser Zentrierung wird die unten aus dem Spinner herausragende Messkapillare, die im Innern des Trägerröhrchens 10 der Empfangsspule 9 zu liegen kommt, radial ausgerichtet, damit keine Berührung zwischen Messkapillare und Empfangsspule vorhanden ist.

Nachdem das Sample gemessen wurde, kann es zusammen mit dem Spinner und mit Hilfe der Pneumatik wieder aus dem Magnetsystem herausgenommen und aus dem Spinner gezogen werden. Der Spinner steht dann zur Messung eines weiteren Samples zur Verfügung.

Das oben beschriebene Verfahren wird für alle Sample-Durchmesser bis hinunter zu 1.7mm eingesetzt. Leider zeigt sich aber, dass dieses Verfahren bei den kleineren Durchmessern sehr kritisch ist und sehr oft zum Glasbruch der Messkapillare führt. Deshalb sind heute für noch kleinere Durchmesser im Bereich von 1 mm keine vertretbaren Lösungen bekannt.

Die oben erwähnte DE 195 09 062 A1 offenbart einen NMR-Probenhalter für flüssige Proben im Mikroliterbereich mit einem dünnen Probenröhrchen konstanten Durchmessers, das, in einem ersten Ausführungsbeispiel, mit einem Stempel und einem Rotor gasdicht verschraubt wird. Auch hier besteht die Problematik eines potentiellen Glasbruchs der Probenröhrchens. In einem anderen Ausführungsbeispiel liegt der Stempel mit der unteren Abschlußfläche einer daran angebrachten Justierschraube auf einer horizontalen Anschlagfläche im Rotor auf und wird z.B. mit einem O-Ring am Rotor fixiert.

Aufgabe der vorliegenden Erfindung ist es demgegenüber, mit möglichst einfachen technischen Mitteln eine Transportvorrichtung für NMR-Messkapitlare so zu modifizieren, dass sie weniger kritisch als die bekannten Vorrichtungen ist, und somit zu weniger Glasbrüchen führt.

Erfindungsgemäß wird diese Aufgabe auf ebenso überraschend einfache wie wirkungsvolle Weise durch eine Vorrichtung gemäß Patentanspruch 1 gelöst.

Um zur erfindungsgemäßen Lösung zu gelangen, war es zuerst notwendig herauszufinden, was verantwortlich für die häufigen Glasbrüche bei bekannten Trahsportvorrichtungen nach dem Stand der Technik ist:

Beim Hinunterfahren des Spinners 7a, wie er in Fig. 1 bei einer Vorrichtung nach dem Stand der Technik gezeigt ist, kann die leicht zerbrechliche Messkapillare 8 auf den konischen Teil des oberen Befestigungsteils 11 des Trägerröhrchens 10 treffen. Da die Messkapillare fest mit dem relativ schweren Spinner 7a verbunden ist, wird dieser ebenfalls abgebremst und überträgt infolge seiner trägen Masse große Kräfte auf die Messkapillare, die dadurch leicht zerstört werden kann. Diese in der Fachwelt bislang nicht realisierte Erkenntnis war eine wichtige Voraussetzung, um zur oben beschriebenen erfindungsgemäßen Problemlösung zu gelangen, die eine weitgehend unkritische Beförderung der Messprobe erlaubt.

Dagegen ermöglicht es die erfindungsgemäße Vorrichtung, die Messkapillare in allen kritischen Richtungen vom Spinner mechanisch zu entkoppeln. Die Messkapillare ist, bezogen auf den Spinner, nach oben in axialer Richtung und seitlich in radialer Richtung frei beweglich, und nur nach unten in axialer Richtung durch einen Anschlag am Spinner aufgrund der zweiten, verengten Stufe der modifizierten Durchgangsbohrung in der Bewegungsfreiheit begrenzt. Die relativen Abmaße der Innendurchmesser der zweistufigen Durchgangsbohrung des Spinners einerseits und des Außendurchmessers der Befestigungshülse andererseits werden in der Praxis so gewählt, dass die Befestigungshülse in der erweiterten ersten Stufe der Durchgangsbohrung lose Platz hat und seitlich in radialer Richtung eine Bewegungsfreiheit von etwa ± 0,5mm bis ± 1 mm oder mehr besitzt. Außerdem sollte die Befestigungshülse zwar mechanisch stabil, aber so leicht wie möglich aufgebaut sein, um die von ihr auf das Probenröhrchen ausgeübten Trägheitskräfte möglichst klein zu halten.

In der erfindungsgemäßen Vorrichtung übt der modifizierte Spinner durch das Zusammenwirken des von der zweiten Stufe der Durchgangsbohrung gebildeten Absatzes mit der horizontalen Abschlussfläche der Befestigungshülse gleichzeitig zwei unterschiedliche Funktionen aus: Er dient sowohl als Transporthilfe zum Einführen des Probenröhrchens in den Messraum des NMR-Magnetsystems als auch zur exakten axialen Positionierung des Probenröhrchens relativ zum NMR-Empfangsspulensystem.

Ein weiterer, wirtschaftlich erheblicher Vorteil der Erfindung liegt darin, dass der Spinner lediglich im Bereich seiner Durchgangsbohrung, also nur in seiner inneren Struktur gegenüber den bekannten Einrichtungen aus dem Stand der Technik modifiziert werden muss. Seine äußeren Abmaße können dagegen unverändert bleiben. Auch die neu hinzukommende, manschettenartig um das Probenröhrchen herum angebrachte Befestigungshülse befindet sich im Betriebszustand, wenn die Probe im Messraum des NMR-Spektrometers positioniert ist, im Innern des Spinners, so dass das erfindungsgemäße Probentransportsystem vollständig kompatibel in vorhandenen Einrichtungen zum pneumatischen Transport von NMR-Messproben einsetzbar ist.

Die in der erfindungsgemäßen Vorrichtung eingesetzte Befestigungshülse kann bei Ausführungsformen eine axiale Sackbohrung aufweisen, mit der die Befestigungshülse von oben über das Probenröhrchen gestülpt werden kann und dabei einerseits als Transporthilfe, andererseits, wie oben beschrieben, als axiale Positioniereinrichtung und außerdem als Verschluss für das Probenröhrchen dienen kann.

Bevorzugt sind jedoch Ausführungsformen, bei denen die Befestigungshülse eine durchgehende Axialbohrung aufweist, in die das Probenröhrchen eingesteckt werden kann.

Besonders bevorzugt ist eine Weiterbildung dieser Ausführungsformen, bei der die Axialbohrung der Befestigungshülse an ihrem oberen Ende eine trichterförmige Erweiterung aufweist, durch welche flüssige Probensubstanz in das Probenröhrchen eingefüllt werden kann, wenn dieses an seinem oberen Ende von der Befestigungshülse radial umgeben ist.

Vorteilhafterweise kann auch ein Probendeckel zum Verschließen des oberen Endes der Befestigungshülse vorgesehen sein, um den Zugang zur Messsubstanz im Probenröhrchen hermetisch abriegeln zu können.

Besonders vorteilhaft ist eine Weiterbildung, bei der auf dem Probendeckel ein DOT-Code zur Identifizierung der im Probenröhrchen befindlichen Messsubstanz angebracht ist. Damit kann die zu untersuchende Substanz automatisch mittels geeigneter Lesevorrichtungen eindeutig identifiziert werden.

Die Befestigungshülse kann durch erhöhten Reibungskontakt verrutschsicher am Probenröhrchen angebracht sein. Es kann aber auch eine feste Verbindung mit dem Probenröhrchen, insbesondere eine Verklebung oder Verschweißung vorgesehen sein, so dass ein Verrutschen der Befestigungshülse beim Auftreffen ihrer horizontalen Abschlussfläche auf die entsprechende Anschlagfläche absolut ausgeschlossen werden kann.

In der NMR-Spektroskopie ist die exakte Zentrierung eines Probenröhrchens in Bezug auf die Sende- und Empfangsspule eine wichtige Voraussetzung, um eine möglichst hohe Empfindlichkeit des NMR-Spektrometers zu erreichen. Insbesondere muss die radiale Zentrierung besonders exakt erfolgen, da zur Erreichung eines möglichst hohen Füllfaktors, der Abstand zwischen der Empfangsspule und dem Probenröhrchen so klein wie möglich sein sollte. Bei immer kleiner werdenden Probenröhrchen muss der Abstand zwischen Empfangsspule und Probenröhrchen linear kleiner werden, um denselben Füllfaktor beizubehalten, und die Anforderungen an die radiale Positionierungsgenauigkeit steigen deshalb ebenfalls linear an. Im Grenzfall, wenn das Probenröhrchen aus einer sogenannten Messkapillare besteht, sind deshalb die Anforderungen an die Genauigkeit der radialen Zentrierung ganz besonders hoch. Solche Messkapillaren werden vorwiegend dann verwendet, wenn die zur Verfügung stehende Menge an Messsubstanz sehr gering ist.

Bekannt beispielsweise durch die eingangs zitierte Firmenbroschüre der Bruker AG ist eine Anordnung, wie sie in Fig. 1 dargestellt ist, wo das Probenröhrchen 8 in den Rotor 7a einer Luftturbine (= Spinner) gesteckt wird, und dieser Spinner auf der konischen Führungsfläche des Stators 2a der Luftturbine, die sich oberhalb der Empfangsspule 9 befindet, axial und radial zentriert wird. Der Stator mit seiner konischen Führungsfläche steht nicht in direkter mechanischer Verbindung mit der Empfangsspule, sondern ist über den unteren Trägerteil 3, anschließend über den unteren Teil des Probenkopfes 4 und schließlich über den oberen Teil 5 des Probenkopfes mit der oberen und unteren Befestigung 11, 12 des Trägerröhrchens 10 der Empfangsspule 9 verbunden. Die Position des Probenröhrchens in Bezug zur Empfangsspule ist somit von sehr vielen Einzelteilen mit verschiedenen mechanischen Toleranzen abhängig, die sich im schlimmsten Fall addieren können und dadurch die Genauigkeit und Reproduzierbarkeit der Zentrierung verschlechtern.

Insbesondere muss erwähnt werden, dass die Distanz zwischen der konischen Führungsfläche und der Empfangsspule relativ groß ist. Dies hat zur Folge, dass kleinste Winkelfehler in der Ausrichtung der Achse der konischen Führungsfläche einen großen Einfluss auf die Position des Probenröhrchens am Ort der Empfangspule haben. Dieser Einfluss ist umso größer, je größer die Distanz zwischen konischer Führungsfläche und Empfangsspule ist.

Ziel einer ganz besonders bevorzugten Ausführungsform der erfindungsgemäßen Vorrichtung ist es daher, die Zentrierungsgenauigkeit gegenüber den oben beschriebenen bekannten Vorrichtungen noch weiter zu steigern, um dadurch auch für Probengläschen in Form von Messkapillaren, bei denen die Anforderung an die Güte der Zentrierung am größten ist, optimale Resultate zu erreichen.

Dieses technische Problem wird gelöst durch eine Ausführungsform der erfindungsgemäßen Vorrichtung, bei der mindestens zwei in axialer Richtung der Empfangsspulenachse voneinander beabstandete, ausschließlich in radialer Richtung auf das Probenröhrchen wirkende Zentrierungseinrichtungen vorgesehen sind, von denen eine oberhalb und die andere unterhalb der Empfangsspule angeordnet ist, wobei die ausschließlich radial wirkenden Zentrierungseinrichtungen mit der Trägervorrichtung zur Befestigung der Empfangsspule starr verbunden sind.

Durch die beiden axial voneinander beabstandeten und ausschließlich radial wirkenden Zentrierungseinrichtungen kann eine optimale radiale Zentrierung des Probenröhrchens auch dann sichergestellt werden, wenn dieses einen sehr geringen Durchmesser aufweist, wie das bei üblichen Messkapillaren der Fall ist, die bei sehr geringen zu untersuchenden Substanzmengen eingesetzt werden. Die erfindungsgemäß vorgesehene starre mechanische Verbindung zwischen den beiden radial wirkenden Zentrierungseinrichtungen und einer Trägervorrichtung, mit der das NMR-Empfangsspulensystem seinerseits starr verbunden ist, stellt sicher, dass die radiale Zentrierung des Probenröhrchens zwangsläufig relativ zum NMR-Empfangsspulensystem erfolgt. Zusätzlich und unabhängig davon ist dann auch noch eine axiale Zentrierung vorgesehen. Damit kann insgesamt eine sehr hohe Genauigkeit der Zentrierung gewährleistet werden. Andererseits ist durch die Trennung der einzelnen Zentrierfunktionen ein besonders hoher Freiheitsgrad für die geometrische Ausgestaltung der gesamten Zentriervorrichtung vorhanden, so dass die Zentrierung geometrisch so nah wie möglich am Empfangsspulensystem bewirkt werden kann.

Besonders bevorzugt ist eine Weiterbildung dieser Ausführungsform, bei der die beiden ausschließlich in radialer Richtung auf das Probenröhrchen wirkenden Zentrierungseinrichtungen mittels in Umfangsrichtung um das Probenröhrchen in dessen Betriebsposition angeordneten, axial ausgedehnten Trägerstangen starr miteinander verbunden sind. Auf diese Weise lässt sich mit technisch extrem einfachen Mitteln und minimalem Materialaufwand eine starre Verbindung zwischen den beiden radial wirkenden Zentrierungseinrichtungen sicherstellen, die die Genauigkeit der Zentrierung des Probenröhrchens noch weiter erhöht.

Vorzugsweise sind die Trägerstangen symmetrisch um das Probenröhrchen herum angeordnet, was ebenfalls der Genauigkeit der Zentrierung zugute kommt.

Besonders bevorzugt sind genau drei Trägerstangen vorgesehen, was einerseits für die mechanische Stabilität der starren Verbindung zwischen den beiden radialen Zentrierungseinrichtungen gerade ausreicht, andererseits viel Spielraum für die Montage des NMR-Empfangsspulensystems schafft.

Die Trägerstangen sollten in jedem Falle aus einem Material gefertigt sein, das keinen Einfluss auf die NMR-Messungen ausübt. Vorteilhafterweise kann für die Trägerstangen Keramik-, Glas- oder Quarzmaterial verwendet werden.

Ganz besonders bevorzugt ist eine Weiterbildung der oben beschriebenen Ausführungsformen, bei der das NMR-Empfangspulensystem ebenfalls starr an den Trägerstangen befestigt ist. Auf diese Weise kann mit den einfachsten technischen Mitteln und geringstmöglichem Materialeinsatz die erfindungsgemäß geforderte starre Verbindung zwischen dem NMR-Empfangsspulensystem und den beiden radial wirkenden Zentrierungseinrichtungen einerseits und die bevorzugte starre Verbindung zwischen den beiden radialen Zentrierungseinrichtungen untereinander andererseits durch eine einzige Befestigungsvorrichtung, nämlich die oben beschriebenen Trägerstangen bewirkt werden, was für die Genauigkeit der Zentrierung optimal ist.

Um einen möglichst großen Füllfaktor erreichen zu können, ist bei einer Weiterbildung der oben beschriebenen Ausführungsformen vorgesehen, dass die Trägerstangen radial um das NMR-Empfangspulensystem herum angeordnet sind und das NMR-Empfangsspulensystem auf der Innenseite dieser Trägerstangen befestigt werden kann.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:
- Fig. 1: einen schematischen Vertikalschnitt durch einen NMR-Probenkopf nach dem Stand der Technik;
- Fig. 2: einen schematischen Vertikalschnitt durch einen NMR-Probenkopf mit erfindungsgemäßer Zentriervorrichtung mit erfindungsgemäß modifiziertem Spinner und Befestigungshülse zum Transport und zur axialen Positionierung des Probenröhrchens;
- Fig. 3: einen schematischen Vertikalschnitt durch ein Probenröhrchen mit erfindungsgemäß in seinem oberen Bereich manschettenartig angebrachter Befestigungshülse;
- Fig. 4: einen schematischen Vertikalschnitt durch ein Probenröhrchen mit erfindungsgemäß in seinem oberen Bereich manschettenartig angebrachter Befestigungshülse mit Probendeckel zum Verschließen des Probenröhrchens;
- Fig. 5a: den Bereich um die NMR-Empfangsspule einer Vorrichtung nach Fig. 2 in größerem Detail; und
- Fig. 5b: eine Horizontalschnitt längs der Linie A - A in Fig. 5a.

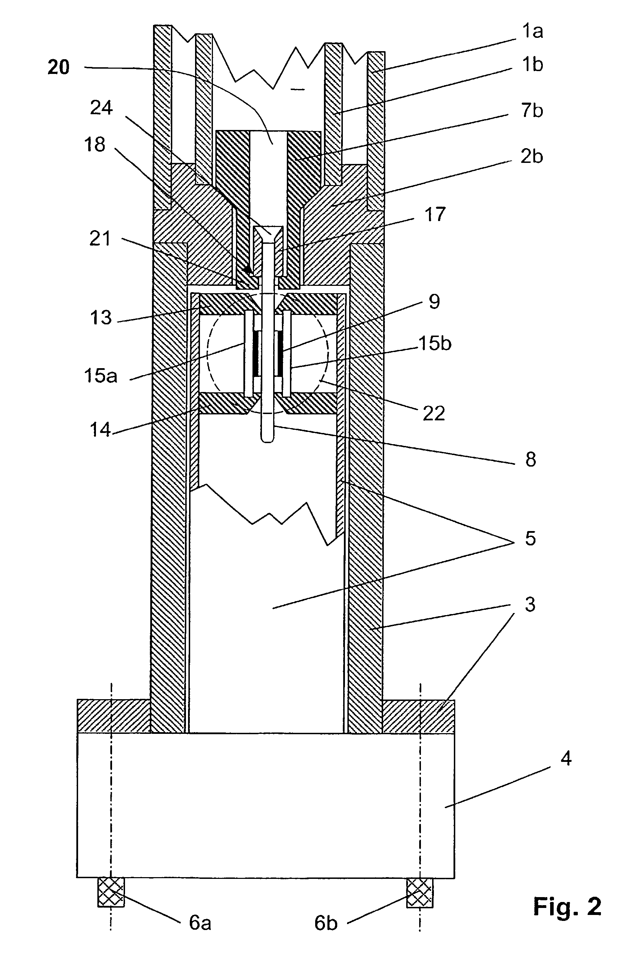

Während Fig. 1 eine Vorrichtung nach dem Stand der Technik darstellt, zeigt Fig. 2 im Vergleich dazu eine Ausführungsform der erfindungsgemäßen Vorrichtung. Die erste Maßnahme der Erfindung besteht darin, die Messkapillare 8 mit einer Befestigungshülse 17 zu versehen, die straff auf der Messkapillare sitzt und sogar mit ihr verklebt oder verschweißt werden darf. Die Messkapillare 8 und die Befestigungshülse 17 bilden somit eine starre Einheit, wobei die Befestigungshülse 17 eine Doppelfunktion ausübt, nämlich erstens die eines Transport- und zweitens die eines Zentrierhilfsmittels für die axiale Positionierung der Messkapillare 8.

Die zweite Massnahme besteht darin, den oberen Teil des Spinners 7b mit einer mindestens zweistufigen Durchgangsbohrung 20 zu versehen. Diese weist in ihrer ersten Stufe im oberen Teil des Spinners 7b einen erheblich größeren Innendurchmesser auf als bei einem Spinner 7a nach dem Stand der Technik, da die Befestigungshülse 17 in die erste Stufe der Bohrung eingeführt werden soll. Eine zweite Stufe im Bodenbereich des Spinners 7b ist so gestaltet, dass im unteren Teil des Spinners 7b ein Absatz 21 übrig bleibt, der zugleich als Transport- wie auch als Zentrierhilfsmittel für die axiale Positionierung des Probenröhrchens 8 mit Befestigungshülse 17 dient. Die größere Bohrung der ersten Stufe ist so bemessen, dass die Befestigungshülse 17 genügend Spiel besitzt, um auch seitlich, d.h. radial, gegenüber dem Spinner 17 frei beweglich zu sein. Das seitliche Spiel sollte mindestens etwa ±0.5 mm bis ±1 mm oder aber mehr betragen. Der Absatz 21 im unteren Bereich des Spinners 7b, auf dessen Anschlagfläche 18 die Befestigungshülse 17 zum Aufliegen kommt, erzeugt die axiale Zentrierung.

Der Spinner 7b, dessen Außenmaße mit denen der konventionellen Spinner 7a übereinstimmen, ist an eine bestehende Pneumatik angepasst, mit der er, auf einem Luftpolster liegend, von oben durch das Führungsrohr 1b nach unten, und umgekehrt von unten wieder nach oben befördert werden kann. Da sich die Befestigungshülse 17 innerhalb des Spinners 7b frei nach oben und in einem beschränkteren Maß auch seitlich bewegen kann, besteht keine Gefahr mehr, dass beim Hinunterfahren des Spinners die leicht zerbrechliche Messkapillare auf den konischen Teil der oberen Zentriervorrichtung 13 aufprallt und dort, durch das relativ große Gewicht des Spinners, zusätzliche Kräfte erfährt, die zu ihrem Bruch führen können. Dadurch, dass keine feste Verbindung zwischen der Befestigungshülse 17 und dem Spinner 7b besteht, kann die Messkapillare auf den konischen Teil der Zentriervorrichtung 13 aufprallen und sich dort problemlos zentrieren, während sich der Spinner 7b an ihr vorbei weiter nach unten bewegt, ohne jedoch die Befestigungshülse 17 samt Messkapillare mitzureißen und dadurch zusätzliche Kräfte auf die Messkapillare auszuüben.

Mit diesen Maßnahmen entsteht eine Transportvorrichtung mit hervorragenden Eigenschaften bezüglich Glasbruchsicherheit. Der Transportvorgang läuft hier wie folgt ab: Sobald die Messkapillare 8 den konischen Teil einer oberen Zentriervorrichtung 13 trifft, deren Funktion unten näher erläutert wird, kann der schwere Spinner 7b ungehindert weiter nach unten fallen, ohne die Messkapillare 8 mitzureißen. Auch wenn die Messkapillare exzentrisch auf die Zentriervorrichtung 13 fällt, können dank ihrer radialen Beweglichkeit ebenfalls keine Kräfte vom Spinner 7b auf die Messkapillare 8 übertragen werden. Versuche mit dieser neuen Transportvorrichtung haben gezeigt, dass Glassbrüche praktisch nicht mehr vorkommen. Auch andere Manipulationen mit dem Spinner samt Messkapillare, z.B. das Tragen von einem Ort zum anderen sind weniger kritisch. Es ist sogar vorgekommen, dass der Spinner zusammen mit der Messkapillare fallengelassen wurde, ohne dass die Messkapillare dadurch Schaden genommen hätten.

Die Befestigungshülse 17 ist so leicht wie möglich aufgebaut, d.h. aus möglichst leichtem Material wie z.B. Kunststoff hergestellt und mit möglichst kleinen Abmessungen dimensioniert. Auf diese Weise vermeidet man, dass die Befestigungshülse 17 größere Trägheitskräfte auf die Messkapillare 8 übertragen kann.

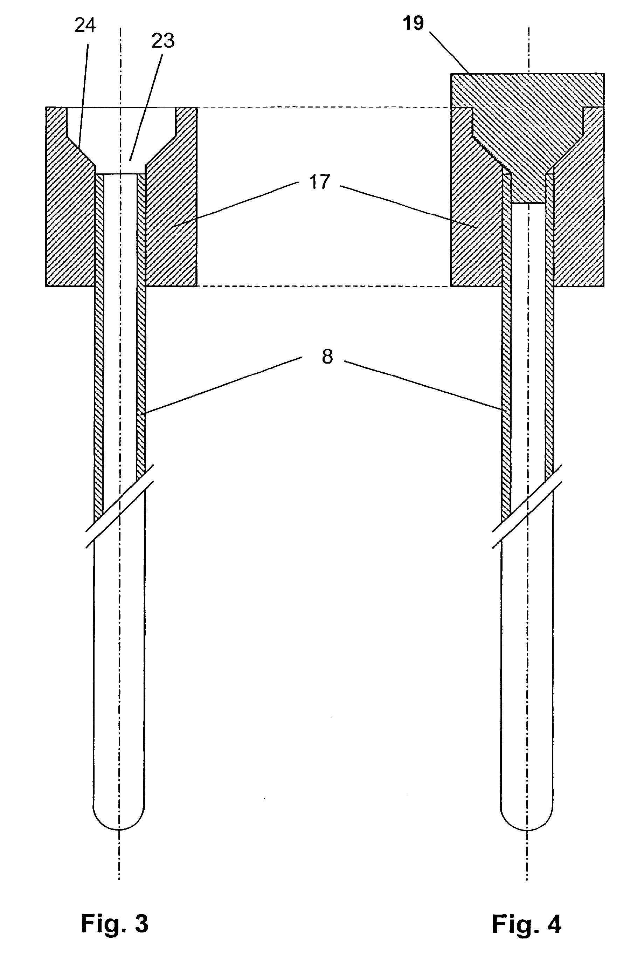

Die Befestigungshülse 17 besitzt bei der in Fig. 3 gezeigten Ausführungsform oben einen Trichter 24, damit eine Spritze, mit der die Probensubstanz in das Probenröhrchen 8 eingespritzt wird, leichter in das Probenröhrchen 8 eingeführt werden kann.

Die Befestigungshülse 17 kann, wie in Fig. 4 gezeigt, mit einem Probendeckel 19 versehen sein, der das Probenröhrchen 8 hermetisch verschließt, um dadurch eine Verdampfung der Probensubstanz weitgehend zu verhindern. Auf dem Probendeckel 19 lässt sich zudem ein Dot-Code anbringen, z.B. durch Aufdrucken, Aufkleben oder Einbrennen, mit dem die Probensubstanz während der gesamten Lebensdauer eindeutig identifiziert werden kann.

Wenn die Messkapillare 8 in der größeren Bohrung des Spinners 7b liegt, ist in Folge der radialen Beweglichkeit keine radiale Zentrierung mehr möglich. Diese wird daher bei der in Fig. 2 gezeigten Ausführungsform der Erfindung von anderen Konstruktionsteilen übernommen werden, nämlich von einer oberen und unteren radialen Zentriereinrichtung 13 resp. 14.

Hierbei wird das Probenröhrchen 8 unmittelbar oberhalb und unterhalb der Empfangsspule 9 mit Hilfe der beiden Zentriervorrichtungen 13 und 14 rein radial zentriert. Da diese Zentrierung so nahe wie möglich bei der Empfangsspule 9 und mit möglichst wenig Zwischenteilen erfolgt, ist eine hohe Genauigkeit der Zentrierung gewährleistet. Wie nahe diese Zentrierung bei der Empfangsspule 9 angebracht werden kann, hängt vom Einfluss der Suszeptibilität der verwendeten Materialien auf die NMR-Auflösung ab, was im Einzelfall experimentell bestimmt werden muss.

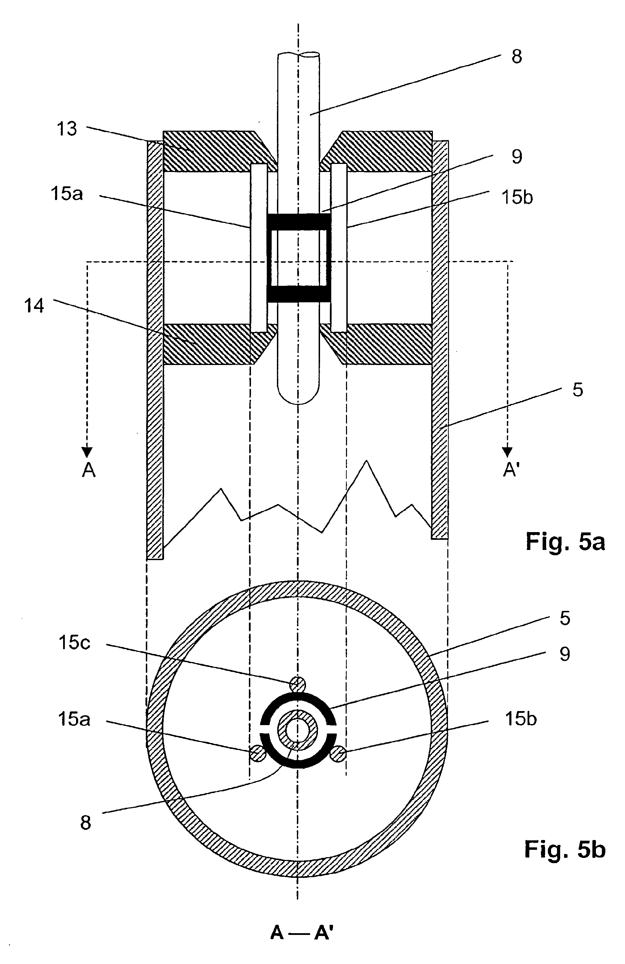

Da mit der erfindungsgemäßen Vorrichtung eine hohe radiale Zentriergenauigkeit erreicht wird, kann zudem die Empfangsspule 9 im Innern ihrer Trägervorrichtung befestigt werden, d.h. unmittelbar um das Probenröhrchen 8 herum mit einem sehr geringen Abstand zueinander, wodurch der erreichbare Füllfaktor sehr hoch wird. Dies ist in den Figuren 5a und 5b näher gezeigt. Voraussetzung für eine solche Anordnung ist jedoch die hohe radiale Zentriergenauigkeit, die eine Beschädigung der Empfangsspule 9 beim Einführen des Probenröhrchens 8 verhindert.

Die Figuren 5a und 5b zeigen, wie die Empfangsspule 9 innen an drei Trägerstangen 15a, 15b und 15c befestigt ist, wie die Trägerstangen durch die beiden radial wirkenden Zentriervorrichtungen 13 und 14 gehalten sind, und wie die beiden Zentriervorrichtungen 13 und 14 das Probenröhrchen 8 leicht berühren und dadurch eine radiale Zentrierung unmittelbar oberhalb und unterhalb der Empfangsspule 9 erzeugen.

### Bezugszeichenliste

- 1a: Oberer Trägerteil (Außenmantel)
- 1b: Oberer Trägerteil (Führungsrohr für den Spinner)
- 1c: Oberer Trägerteil (unterer Abschlussflansch)
- 2a: Stator der Luftturbine von Fig. 1 und Fig. 2
- 3: Unterer Trägerteil
- 4: Unterer Teil des Probenkopfes
- 5: Oberer Teil des Probenkopfes
- 6a, b: Befestigungsschrauben. Diese sind von Hand abschraubbar, damit der Probenkopf leicht entfernt werden kann.
- 7a: Rotor (= Spinner) der Luftturbine von Fig. 1 nach dem Stand der Technik
- 7b: Rotor (= Spinner) der Luftturbine von Fig. 2. Diese ermöglicht zugleich einen sicheren Transport und eine reine axiale Positionierung des Probenröhrchens 8
- 8: Probenröhrchen
- 9: Empfangsspule (sattelförmig)
- 10: Trägerröhrchen der Empfangsspule 9
- 11: Oberer Befestigungsteil des Trägerröhrchens 10
- 12: Unterer Befestigungsteil des Trägerröhrchens 10
- 13: Obere radiale Zentriereinrichtung für das Probenröhrchen 8. Dient zugleich auch als obere Befestigung der drei Trägerstangen, 15a, 15b und 15c der Empfangsspule 9.
- 14: Untere radiale Zentriereinrichtung für das Probenröhrchen 8. Dient zugleich auch als untere Befestigung der drei Trägerstangen, 15a, 15b und 15c der Empfangsspule 9.
- 15a,b,c: Trägerstangen zur Befestigung der Empfangsspule 9
- 17: Befestigungshülse des Probenröhrchens. Sie erlaubt eine axiale Positionierung des Probenröhrchens im Spinner.
- 18: Anschlagfläche
- 19: Probendeckel zum Verschließen des Probenröhrchens und zum Anbringen eines "dot code" zur Identifikation der Messprobe.
- 20: Zweistufige Bohrung des Spinners
- 21: Unterer Absatz im Bodenbereich des Spinners
- 22: Messraum
- 23: Axiale Durchgangsbohrung der Befestigungshülse 17
- 24: Trichterförmige Erweiterung am oberen Ende der Befestigungshülse 17, um die Messsubstanz leichter in das Probenröhrchen 8 einfüllen zu können.

## Patentansprüche

1. Vorrichtung zum Transport eines mit einer Messsubstanz gefüllten länglichen Probenröhrchens (8) in den Messraum (22) eines Kernspinresonanz (=NMR)-Magnetsystems, sowie zur Positionierung des Probenröhrchens (8) relativ zur Vertikalachse eines NMR-Empfangspulensystems (9), mit einem Spinner, der Teil einer Luftturbine ist und eine axiale Durchgangsbohrung aufweist, durch welche das Probenröhrchen (8) gesteckt, zusammen mit dem Spinner auf einem Luftkissen in den Messraum (22) befördert und dort relativ zur Vertikalachse des NMR-Empfangspulensystems (9) positioniert werden kann, wobei eine manschettenartig und verrutschsicher radial um das Probenröhrchen (8) herum anzubringende Befestigungshülse (17) vorgesehen ist, und wobei die Bohrung (20) in einer ersten Stufe im oberen Bereich des Spinners (7b) einen Innendurchmesser aufweist, der größer ist als der Außendurchmesser der Befestigungshülse (17), in einer zweiten Stufe im Bodenbereich des Spinners (7b) einen Innendurchmesser, der kleiner ist als der Außendurchmesser der Befestigungshülse (17), aber größer als der Außendurchmesser des Probenröhrchens (8).
**dadurch gekennzeichnet,**
**dass** die Befestigungshülse, in Betriebsposition des Probenröhrchens (8) im Messraum (22), mit einer horizontalen, unteren Abschlussfläche auf der durch den Übergang von der ersten zur zweiten Stufe der Durchgangsbohrung gebildeten, horizontalen Anschlagfläche (18) im Bodenbereich des Spinners (7b) eben aufliegt, wobei das Probenröhrchen (8) zusammen mit der daran angebrachten Befestigungshülse (17), bezogen auf den Spinner, nach oben in axialer Richtung und seitlich in radialer Richtung frei beweglich, und nur nach unten in axialer Richtung durch die Anschlagfläche (18) in der Bewegungsfreiheit begrenzt ist.

2. Vorrichtung nach Anspruch 1, **dadurch gekennzeichnet, dass** die Befestigungshülse (17) eine durchgehende Axialbohrung (23) aufweist, in die das Probenröhrchen (8) eingesteckt werden kann.

3. Vorrichtung nach Anspruch 2, **dadurch gekennzeichnet, dass** die Axialbohrung (23) der Befestigungshülse (17) an ihrem oberen Ende eine trichterförmige Erweiterung (24) aufweist, durch welche flüssige Probensubstanz in das Probenröhrchen (8) eingefüllt werden kann, wenn dieses an seinem oberen Ende von der Befestigungshülse (17) radial umgeben ist.

4. Vorrichtung nach Anspruch 2 oder 3, **dadurch gekennzeichnet, dass** ein Probendeckel (19) zum Verschließen des oberen Endes der Befestigungshülse (17) vorgesehen ist.

5. Vorrichtung nach Anspruch 4, **dadurch gekennzeichnet, dass** auf dem Probendeckel (19) ein DOT-Code zur Identifizierung der im Probenröhrchen (8) befindlichen Messsubstanz angebracht ist.

6. Vorrichtung nach einem der vorhergehenden Ansprüche, **dadurch gekennzeichnet, dass** die Befestigungshülse (17) fest mit dem Probenröhrchen (8) verbunden, insbesondere verklebt oder verschweißt ist.

7. Vorrichtung nach einem der vorhergehenden Ansprüche, **dadurch gekennzeichnet, dass** mindestens zwei in axialer Richtung der Vertikalachse des Empfangsspulensystems (9) voneinander beabstandete, ausschließlich in radialer Richtung auf das Probenröhrchen (8) wirkende Zentrierungseinrichtungen (13, 14) vorgesehen sind, von denen eine oberhalb und die andere unterhalb des NMR-Empfangsspulensystems (9) angeordnet ist, wobei die ausschließlich radial wirkenden Zentrierungseinrichtungen (13, 14) mit einer Trägervorrichtung zur Befestigung des NMR-Empfangsspulensystems (9) starr verbunden sind.

8. Vorrichtung nach Anspruch 7, **dadurch gekennzeichnet, dass** die beiden ausschließlich in radialer Richtung auf das Probenröhrchen (8) wirkenden Zentrierungseinrichtungen (13, 14) mittels in Umfangsrichtung um das Probenröhrchen (8) in dessen Betriebsposition angeordneten, axial ausgedehnten Trägerstangen (15a, 15b, 15c) starr miteinander verbunden sind.

9. Vorrichtung nach Anspruch 8, **dadurch gekennzeichnet, dass** die Trägerstangen (15a, 15b, 15c) symmetrisch um das Probenröhrchen (8) herum angeordnet sind.

10. Vorrichtung nach Anspruch 9, **dadurch gekennzeichnet, dass** drei Trägerstangen (15a, 15b, 15c) vorgesehen sind.

11. Vorrichtung nach einem der Ansprüche 8 bis 10, **dadurch gekennzeichnet, dass** die Trägerstangen (15a, 15b, 15c) aus Keramik-, Glas- oder Quarzmaterial aufgebaut sind.

12. Vorrichtung nach einem der Ansprüche 8 bis 11, **dadurch gekennzeichnet, dass** das NMR-Empfangspulerisystem (9) ebenfalls starr an den Trägerstangen (15a, 15b, 15c) befestigt ist.

13. Vorrichtung nach einem der Ansprüche 8 bis 12, **dadurch gekennzeichnet, dass** die Trägerstangen (15a, 15b, 15c) radial um das NMR-Empfangspulensystem (9) herum angeordnet sind.

## Claims

1. Device for transporting an elongated sample tube (8), filled with a measuring substance, into the measuring chamber (22) of a nuclear magnetic resonance (=NMR) magnet system and for positioning the sample tube (8) relative to the vertical axis of an NMR receiver coil system (9), having a spinner which is part of an air turbine and comprises an axial through-bore through which the sample tube (8) can be inserted, transported together with the spinner on an air cushion into the measuring chamber (22), and positioned there relative to the vertical axis of the NMR receiver coil system (9),
wherein a mounting sleeve (17) is to be provided which is disposed like a collar radially about the sample tube (8) in a slipsafe manner and, wherein the inner diameter of the bore (20) in a first stage at the upper region of the spinner (7b) is larger than the outer diameter of the mounting sleeve (17), and wherein the inner diameter in a second stage at the bottom region of the spinner (7b) is smaller than the outer diameter of the mounting sleeve (17), but larger than the outer diameter of the sample tube (8),
**characterized in**
**that** the mounting sleeve, in the operating position of the sample tube (8) in the measuring chamber (22), flatly abuts with a horizontal lower end face thereof, formed by the transition from the first to the second stage of the through-bore on a horizontal stop surface (18) in the bottom region of the spinner (7b), wherein the sample tube (8), together with the mounting sleeve (17) provided thereon, in relation to the spinner, is freely moveable upwardly in the axial direction and is freely moveable laterally in the radial direction and is limited in its freedom of movement only downwards in the axial direction by means of the stop surface (18).

2. Device according to claim 1, **characterized in that** the mounting sleeve (17) has an axial through-bore (23) into which the sample tube (8) can be inserted.

3. Device according to claim 2, **characterized in that** the upper end of the axial bore (23) of the mounting sleeve (17) has a funnel-shaped extension (24) through which liquid sample substance can be filled into the sample tube (8) when its upper end is radially surrounded by the mounting sleeve (17).

4. Device according to claim 2 or 3, **characterized in that** a sample lid (19) is provided for closing the upper end of the mounting sleeve (17).

5. Device according to claim 4, **characterized in that** a DOT code is provided on the sample lid (19) for identifying the measuring substance located in the sample tube (8).

6. Device according to any one of the preceding claims, **characterized in that** the mounting sleeve (17) is rigidly connected to the sample tube (8), in particular bonded or welded.

7. Device according to any one of the preceding claims, **characterized in that** at least two centering means (13, 14) are provided which are separated from each other in the axial direction of the vertical axis of the receiver coil system (9) and act on the sample tube (8) in the radial direction only, one of which is disposed above and the other below the NMR receiver coil system (9), wherein the only radially acting centering means (13,14) are rigidly connected to a support device for mounting the NMR receiver coil system (9).

8. Device according to claim 7, **characterized in that** the two centering means (13,14) which act on the sample tube (8) in the radial direction only are rigidly connected to each other by means of axially extended support rods (15a,15b,15c) which are disposed in the circumferential direction about the sample tube (8) in its operating position.

9. Device according to claim 8, **characterized in that** the support rods (15a, 15b, 15c) are disposed symmetrically around the sample tube (8).

10. Device according to claim 9, **characterized in that** three support rods (15a, 15b, 15c) are provided.

11. Device according to any one of the claims 8 through 10, **characterized in that** the support rods (15a, 15b, 15c) are made from ceramic, glass or quartz material.

12. Device according to any one of the claims 8 through 11, **characterized in that** the NMR receiver coil system (9) is also rigidly mounted to the support rods (15a, 15b, 15c).

13. Device according to any one of the claims 8 through 12, **characterized in that** the support rods (15a, 15b, 15c) are disposed in a radial direction about the NMR receiver coil system (9).

## Revendications

1. Dispositif de transport d'une éprouvette (8) oblongue remplie d'une substance à mesurer dans la chambre de mesure (22) d'un système à résonance magnétique nucléaire (RMN), ainsi que de positionnement de l'éprouvette (8) par rapport à l'axe vertical d'un système de bobines réceptrices RMN (9), avec un spinner qui fait partie d'une turbine à air et qui présente un trou traversant axial à travers lequel l'éprouvette (8) peut être introduite, transportée avec le spinner sur un coussin d'air dans la chambre de mesure (22) et y être positionnée par rapport à l'axe vertical du système de bobines réceptrices RMN (9), un manchon de fixation (17) à installer à la manière d'une manchette et sans possibilité de glissement radial autour de l'éprouvette (8) étant prévu, et le trou (20) présentant à un premier étage dans la zone supérieure du spinner (7b) un diamètre intérieur qui est supérieur au diamètre extérieur du manchon de fixation (17), à un deuxième étage dans la zone de fond du spinner (7b) un diamètre intérieur qui est inférieur au diamètre extérieur du manchon de fixation (17) mais supérieur au diamètre extérieur de l'éprouvette (8),
**caractérisé en ce**
**que** le manchon de fixation, dans la position d'utilisation de l'éprouvette (8) dans la chambre de mesure (22), repose à plat par une surface terminale inférieure horizontale sur la surface de butée (18) horizontale formée par la transition du premier au deuxième étage du trou traversant dans la zone de fond du spinner (7b), l'éprouvette (8) avec le manchon de fixation (17) installé dessus étant librement mobile vers le haut en direction axiale et latéralement en direction radiale par rapport au spinner et étant limitée dans sa liberté de mouvement seulement vers le bas en direction axiale par la surface de butée (18).

2. Dispositif selon la revendication 1, **caractérisé en ce que** le manchon de fixation (17) présente un trou axial traversant (23) dans lequel l'éprouvette (8) peut être introduite.

3. Dispositif selon la revendication 2, **caractérisé en ce que** le trou axial (23) du manchon de fixation (17) présente à son extrémité supérieure un élargissement (24) en forme d'entonnoir par lequel une substance échantillon liquide peut être versée dans l'éprouvette (8) quand celle-ci est entourée radialement à son extrémité supérieure par le manchon de fixation (17).

4. Dispositif selon la revendication 2 ou 3, **caractérisé en ce qu'**il est prévu un couvercle d'échantillon (19) pour fermer l'extrémité supérieure du manchon de fixation (17).

5. Dispositif selon la revendication 4, **caractérisé en ce qu'**un code DOT d'identification de la substance à mesurer se trouvant dans l'éprouvette (8) est appliqué sur le couvercle d'échantillon (19).

6. Dispositif selon une des revendications précédentes, **caractérisé en ce que** le manchon de fixation (17) est relié rigidement, en particulier collé ou soudé, à l'éprouvette (8).

7. Dispositif selon une des revendications précédentes, **caractérisé en ce qu'**il est prévu au moins deux dispositifs de centrage (13, 14) distants l'un de l'autre en direction axiale de l'axe vertical du système de bobines réceptrices (9), agissant exclusivement en direction radiale sur l'éprouvette (8), dont l'un est disposé au-dessus et l'autre au-dessous du système de bobines réceptrices RMN (9), les dispositifs de centrage (13, 14) agissant exclusivement en direction radiale étant reliés rigidement à un dispositif de support servant à la fixation du système de bobines réceptrices RMN (9).

8. Dispositif selon la revendication 7, **caractérisé en ce que** les deux dispositifs de centrage (13, 14) agissant exclusivement en direction radiale sur l'éprouvette (8) sont reliés rigidement l'un à l'autre au moyen de tiges de support (15a, 15b, 15c) allongées axialement, disposées en direction circonférentielle autour de l'éprouvette (8) dans sa position d'utilisation.

9. Dispositif selon la revendication 8, **caractérisé en ce que** les tiges de support (15a, 15b, 15c) sont disposées symétriquement autour de l'éprouvette (8).

10. Dispositif selon la revendication 9, **caractérisé en ce que** trois tiges de support (15a, 15b, 15c) sont prévues.

11. Dispositif selon une des revendications 8 à 10, **caractérisé en ce que** les tiges de support (15a, 15b, 15c) sont réalisées en céramique, verre ou quartz.

12. Dispositif selon une des revendications 8 à 11, **caractérisé en ce que** le système de bobines réceptrices RMN (9) est également fixé rigidement aux tiges de support (15a, 15b, 15c).

13. Dispositif selon une des revendications 8 à 12, **caractérisé en ce que** les tiges de support (15a, 15b, 15c) sont disposées radialement autour du système de bobines réceptrices RMN (9).
